# EUROPÄISCHE PATENTANMELDUNG

(11) **EP 3 651 033 A1**
(43) Veröffentlichungstag der Anmeldung: **13.05.2020**
(21) Anmeldenummer: 18205482.5
(22) Anmeldetag: 09.11.2018
(51) Int. Cl.: G06F 17/50, G06K 9/00, G06F 16/25, G06F 16/11, G06F 16/178

(54) **VORRICHTUNG UND VERFAHREN ZUM ERZEUGEN VON NEUTRALDATEN FÜR EINE PRODUKTSPEZIFIKATION**

(71) Anmelder: Phoenix Contact GmbH & Co. KG, 32825 Blomberg (DE)
(72) Erfinder: Keller, Peter, 33813 Oerlinghausen (DE); Schmidt, Jörg, 32469 Petershagen (DE); Tieben, Matthias, 32105 Bad Salzuflen (DE); Frenser, Jens, 32756 Detmold (DE)
(74) Vertreter: Maiwald Patent- und Rechtsanwaltsgesellschaft mbH

(57) **Zusammenfassung**

Die vorliegende Erfindung betrifft ein Verfahren zum Erzeugen von Neutraldaten für eine Produktspezifikation, wobei das Verfahren in einem Rechnernetz durchgeführt wird und folgende Verfahrensschritte aufweist: Konfigurieren (S1) und Bereitstellen der Produktspezifikation; Semantisieren (S2) von Produktmodelldaten für eine Vielzahl von unterschiedlichen Produktspezifikationen aus einer Datenbank zu semantisierten Produktmodelldaten, wobei die Datenbank eine Vielzahl von Produktmodelldaten durch eine Variantenmodellierung bereitstellt; Orchestrieren (S3) von Datenverarbeitungsprozessen der Produktmodelldaten zu orchestrierten Datenverarbeitungsprozessen; und Transformieren (S4) der semantisierten Produktmodelldaten mittels der orchestrierten Datenverarbeitungsprozesse basierend auf der konfigurierten Produktspezifikation zu den Neutraldaten der Produktspezifikation.

## Beschreibung

### Technisches Gebiet

Die vorliegende Erfindung betrifft Systeme für die Datengeneration durch standardisierte Datenerzeugungsprozesse und entsprechenden Datengenerationsverfahren für die computerunterstütze Fertigung.

Insbesondere betrifft die vorliegende Erfindung eine Vorrichtung und ein Verfahren zum Erzeugen von Neutraldaten für eine Produktspezifikation.

### Technischer Hintergrund

Daten zu Produkten liegen in einem Unternehmen im Bereich der Produktbeschaffung, der Produktion und der Distribution vor. Eine durchgehende Implementierung einer weitreichenden Datenverfügbarkeit und Datentransformation ist nur schwer möglich.

### Zusammenfassung der Erfindung

Es ist eine Aufgabe der vorliegenden Erfindung, eine verbesserte Vorrichtung und ein verbessertes Verfahren zum Erzeugen von Neutraldaten für eine Produktspezifikation bereitzustellen.

Diese Aufgabe wird durch die Gegenstände der unabhängigen Patentansprüche gelöst. Weiterbildungen und Ausführungsformen sind den abhängigen Patentansprüchen, der Beschreibung und den Figuren der Zeichnungen zu entnehmen.

Ein erster Aspekt der vorliegenden Erfindung betrifft ein Verfahren zum Erzeugen von Neutraldaten für eine Produktspezifikation, wobei das Verfahren folgende Verfahrensschritte umfasst.

Als ein erster Verfahrensschritt erfolgt ein Konfigurieren und ein Bereitstellen der Produktspezifikation.

Als ein zweiter Verfahrensschritt erfolgt ein Semantisieren von Produktmodelldaten für eine Vielzahl von unterschiedlichen Produktspezifikationen aus einer Datenbank zu semantisierten Produktmodelldaten, wobei die Datenbank eine Vielzahl von Produktmodelldaten durch eine Variantenmodellierung bereitstellt.

Als ein dritter Verfahrensschritt erfolgt ein Orchestrieren von Datenverarbeitungsprozessen der Produktmodelldaten zu orchestrierten Datenverarbeitungsprozessen.

Als ein vierter Verfahrensschritt erfolgt ein Transformieren der semantisierten Produktmodelldaten mittels der orchestrierten Datenverarbeitungsprozesse basierend auf der konfigurierten Produktspezifikation zu den Neutraldaten der Produktspezifikation.

Die vorliegende Erfindung ermöglicht, die Erzeugung und Bereitstellung von Neutraldaten aus einer Konfiguration zu erreichen, wobei sämtliche für die Geschäftsprozessabwicklung erforderliche Informationen digital über eine Orchestrierung für Produktionsanlagen und Backendsysteme vollständig abgeleitet werden können, wobei Neuprodukte, Bestandsprodukte und kundenindividuelle Produkten und Produktvarianten abgedeckt werden.

Die vorliegende Erfindung ermöglicht, dass in adaptierter und vollautomatisch angepasster Weise auf verschiedene Konfigurationsszenarien einer Produktionsspezifikation etwa bei der Produktherstellung oder auch der weiteren Datenverarbeitung reagiert werden kann.

Vorteilhafte Ausgestaltungen der vorliegenden Erfindung sind den Unteransprüchen zu entnehmen.

In einer vorteilhaften Ausführungsform der vorliegenden Erfindung ist vorgesehen, dass das Verfahren durch eine verteilte Verarbeitung in dem Rechnernetz ausgeführt wird, beispielsweise ist das Rechnernetz als ein verteiltes und/oder dezentrales Computersystem ausgebildet.

In einer vorteilhaften Ausführungsform der vorliegenden Erfindung ist vorgesehen, dass als die Produktspezifikation eine:
i) kundenindividuelle Produktspezifikation; und/oder
ii) Bestandsprodukt-Spezifikation; und/oder
iii) Neuprodukt-Spezifikation
verwendet wird.

In einer vorteilhaften Ausführungsform der vorliegenden Erfindung ist vorgesehen, dass das Konfigurieren der Produktspezifikation von einem Webkonfigurator zur kundenindividuellen Produktkonfiguration, einem Webshop, einem Simulationssystem, einem Enterprise-Resource-Planning-System, einem Produktionsleitsystem, oder einem Montagehilfsautomat durchgeführt wird.

In einer vorteilhaften Ausführungsform der vorliegenden Erfindung ist vorgesehen, dass die Produktmodelldaten für die Vielzahl der unterschiedlichen Produktspezifikationen basierend auf einem Entity-Relationship-Modell semantisiert werden.

In einer vorteilhaften Ausführungsform der vorliegenden Erfindung ist vorgesehen, dass die Variantenmodellierung durch einen webbasierten und/oder interaktiven Produktkonfigurator bereitgestellt wird.

In einer vorteilhaften Ausführungsform der vorliegenden Erfindung ist vorgesehen, dass die Neutraldaten in einem Neutraldaten-Format bereitgestellt werden, wobei das Neutraldaten-Format ein
i) XML-Format; und/oder
ii) plattformunabhängiges Datenformat; und/oder
iii) implementationsunabhängiges Datenformat; und/oder
iv) M2M-Datenformat
umfasst. Das M2M-Datenformat kann als bedarfsspezifisches Format für Maschinen, Prozesse und Verfahren angepasst werden, an die jeweilig verwendete Datenverarbeitungseinrichtung, welche jeweils unterschiedliche Anforderungen an das Neutraldaten-Format aufweisen kann.

Der Begriff "M2M" wie von der vorliegenden Erfindung verwendet bezeichnet dabei "Machine-to-Machine" und definiert den automatisierten Informationsaustausch zwischen Endgeräten wie Maschinen, Automaten, oder Produktionsmaschinen untereinander oder mit einer zentralen Rechnereinheit, Server, des Rechnernetzes als ein verteiltes und/oder dezentrales Computersystem.

In einer vorteilhaften Ausführungsform der vorliegenden Erfindung ist vorgesehen, dass für das Orchestrieren der Datenverarbeitungsprozesse die Datenverarbeitungsdienste einer Produktionsanlage und/oder eines Backendsystems des Rechnernetzes orchestriert werden. Das Backendsystem kann unterschiedliche Datenverarbeitungseinrichtung umfassen.

In einem zweiten Aspekt der vorliegenden Erfindung ist eine Vorrichtung zum Erzeugen von Neutraldaten für eine Produktspezifikation vorgesehen, wobei die Vorrichtung ein Konfigurationsmodul, ein Semantikmodul, und ein Orchestrierungsmodul und ein Transformationsmodul umfasst:
Das Konfigurationsmodul ist dazu ausgebildet, eine Produktspezifikation zu konfigurieren und bereitzustellen.

Das Semantikmodul ist dazu ausgebildet, Produktmodelldaten für eine Vielzahl von unterschiedlichen Produktspezifikationen zu semantisierten Produktmodelldaten aus einer mit dem Rechnernetz gekoppelten Datenbank zu semantisieren, wobei die Datenbank eine Vielzahl von Produktmodelldaten generiert durch eine Variantenmodellierung umfasst.

Das Orchestrierungsmodul ist dazu ausgebildet, Datenverarbeitungsprozesse der Produktmodelldaten zu orchestrierten Datenverarbeitungsprozessen zu orchestrieren.

Das Transformationsmodul ist dazu ausgebildet, semantisierte Produktmodelldaten mittels der orchestrierten Datenverarbeitungsprozesse basierend auf der konfigurierten Produktspezifikation zu den Neutraldaten der Produktspezifikation zu transformieren.

In einer vorteilhaften Ausführungsform der vorliegenden Erfindung ist vorgesehen, dass die Vorrichtung als ein verteiltes Rechnernetz ausgebildet ist.

In einer vorteilhaften Ausführungsform der vorliegenden Erfindung ist vorgesehen, dass das Konfigurationsmodul dazu ausgebildet, als die Produktspezifikation eine:
i) kundenindividuelle Produktspezifikation; und/oder
ii) Bestandsprodukt-Spezifikation; und/oder
iii) Neuprodukt-Spezifikation
bereitzustellen.

In einer vorteilhaften Ausführungsform der vorliegenden Erfindung ist vorgesehen, dass das Konfigurationsmodul dazu ausgebildet ist, das Konfigurieren und Bereitstellen der Produktspezifikation durch einen Webkonfigurator, einen Webshop, ein Simulationssystem, ein Enterprise-Resource-Planning-System, ein Produktionsleitsystem, oder einen Montagehilfsautomaten durchzuführen.

In einer vorteilhaften Ausführungsform der vorliegenden Erfindung ist vorgesehen, dass das Semantikmodul dazu ausgebildet ist, die Produktmodelldaten für die Vielzahl der unterschiedlichen Produktspezifikationen basierend auf einem Entity-Relationship-Modell zu semantisieren.

In einer vorteilhaften Ausführungsform der vorliegenden Erfindung ist vorgesehen, dass die Vorrichtung dazu ausgebildet ist, die Neutraldaten in einem Neutraldaten-Format bereitzustellen, wobei das Neutraldaten-Format ein
i) XML-Format; und/oder
ii) plattformunabhängiges Datenformat; und/oder
iii) implementationsunabhängiges Datenformat; und/oder
iii) M2M-Datenformat
umfasst.

In einem dritten Aspekt der vorliegenden Erfindung ist ein Rechnernetzsystem vorgesehen, umfassend die Vorrichtung zum Erzeugen von Neutraldaten für eine Produktspezifikation gemäß dem zweiten Aspekt der vorliegenden Erfindung, ferner umfassend eine Datenbank, welche einen webbasierten und/oder interaktiven Produktkonfigurator aufweist, welcher dazu ausgebildet ist, die Vielzahl der Produktmodelldaten durch die Variantenmodellierung zu generieren.

In einem vierten Aspekt der vorliegenden Erfindung ist ein Computerprogramm oder Computerprogrammprodukt vorgesehen, umfassend Befehle, die bei der Ausführung des Programms durch einen Computer diesen veranlassen, die Schritte des Verfahrens zum Erzeugen von Neutraldaten in einem Rechnernetz gemäß dem ersten Aspekt der vorliegenden Erfindung auszuführen.

In einem fünften Aspekt der vorliegenden Erfindung ist ein Computerlesbares (Speicher)medium vorgesehen, umfassend Befehle, die bei der Ausführung durch einen Computer diesen veranlassen, die Schritte des Verfahrens zum Erzeugen von Neutraldaten in einem Rechnernetz gemäß dem ersten Aspekt der vorliegenden Erfindung auszuführen.

Die beschriebenen Ausgestaltungen und Weiterbildungen lassen sich beliebig miteinander kombinieren.

Weitere mögliche Ausgestaltungen, Weiterbildungen und Implementierungen der vorliegenden Erfindung umfassen auch nicht explizit genannte Kombinationen von zuvor oder im Folgenden bezüglich der Ausführungsformen beschriebenen Merkmale der vorliegenden Erfindung.

Die beiliegenden Zeichnungen sollen ein weiteres Verständnis der Ausführungsformen der vorliegenden Erfindung vermitteln. Die beiliegenden Zeichnungen veranschaulichen Ausführungsformen und dienen im Zusammenhang mit der Beschreibung der Erklärung von Konzepten der vorliegenden Erfindung.

Andere Ausführungsformen und viele der genannten Vorteile ergeben sich im Hinblick auf die Figuren der Zeichnungen. Die dargestellten Elemente der Figuren der Zeichnungen sind nicht notwendigerweise maßstabsgetreu zueinander gezeigt.

### Kurze Beschreibung der Figuren

Es zeigen:
- Fig. 1:: eine schematische Darstellung einer Vorrichtung zum Erzeugen von Neutraldaten für eine Produktspezifikation gemäß einem Ausführungsbeispiel der vorliegenden Erfindung;
- Fig. 2:: eine schematische Darstellung eines Flussdiagramms eines Verfahrens zum Erzeugen von Neutraldaten für eine Produktspezifikation gemäß einem Ausführungsbeispiel der vorliegenden Erfindung; und
- Fig. 3: eine schematische Darstellung einer Prozessvisualisierung eines Verfahrens zum Erzeugen von Neutraldaten für eine Produktspezifikation gemäß einem Ausführungsbeispiel der vorliegenden Erfindung.

### Detaillierte Beschreibung der Ausführungsbeispiele

In den Figuren der Zeichnungen bezeichnen gleiche Bezugszeichen gleiche oder funktionsgleiche Elemente, Bauteile, Komponenten oder Verfahrensschritte, soweit nichts Gegenteiliges angegeben ist.

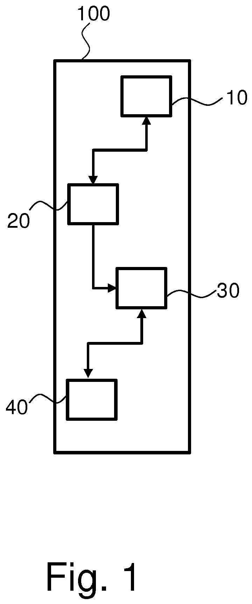

Die Fig. 1 zeigt eine schematische Darstellung einer Vorrichtung zum Erzeugen von Neutraldaten für eine Produktspezifikation gemäß einem Ausführungsbeispiel der vorliegenden Erfindung.

Die Vorrichtung 100 umfasst ein Konfigurationsmodule 10, ein Semantikmodul 20, und ein Orchestrierungsmodul 30 und ein Transformationsmodul 40.

Das Konfigurationsmodul 10 ist dazu ausgebildet, eine Produktspezifikation zu konfigurieren und bereitzustellen.

Das Semantikmodul 20 ist dazu ausgebildet, Produktmodelldaten für eine Vielzahl von unterschiedlichen Produktspezifikationen zu semantisierten Produktmodelldaten aus einer mit dem Rechnernetz gekoppelten Datenbank zu semantisieren, wobei die Datenbank eine Vielzahl von Produktmodelldaten generiert durch eine Variantenmodellierung umfasst.

Mit anderen Worten ausgedrückt, das Semantikmodul 20 ist dazu ausgebildet, semantischen Beziehungen zwischen erfassten Funktion von einzelnen Rechnern des Rechnernetzes zu bestimmen.

Das Orchestrierungsmodul 30 ist dazu ausgebildet, eine Orchestrierung durchzuführen und Datenverarbeitungsprozesse der Produktmodelldaten zu orchestrierten Datenverarbeitungsprozessen zu orchestrieren.

Das Transformationsmodul 40 ist dazu ausgebildet, semantisierte Produktmodelldaten mittels der orchestrierten Datenverarbeitungsprozesse basierend auf der konfigurierten Produktspezifikation zu den Neutraldaten der Produktspezifikation zu transformieren.

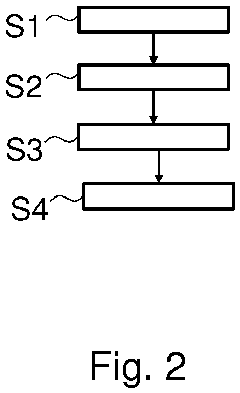

Die Fig. 2 eine schematische Darstellung eines Flussdiagramms eines Verfahrens zum Erzeugen von Neutraldaten für eine Produktspezifikation gemäß einem Ausführungsbeispiel der vorliegenden Erfindung.

Als ein erster Verfahrensschritt erfolgt ein Konfigurieren S1 und ein Bereitstellen der Produktspezifikation.

Als ein zweiter Verfahrensschritt erfolgt ein Semantisieren S2 von Produktmodelldaten für eine Vielzahl von unterschiedlichen Produktspezifikationen aus einer Datenbank zu semantisierten Produktmodelldaten, wobei die Datenbank eine Vielzahl von Produktmodelldaten durch eine Variantenmodellierung bereitstellt.

Als ein dritter Verfahrensschritt erfolgt ein Orchestrieren S3 von Datenverarbeitungsprozessen der Produktmodelldaten zu orchestrierten Datenverarbeitungsprozessen

Das Orchestrieren S3 umfasst beispielsweise eine Orchestrierung in der Form eines flexiblen Kombinierens von Funktionen der Datenverarbeitungsprozesse der Produktmodelldaten.

Als ein vierter Verfahrensschritt erfolgt ein Transformieren S4 der semantisierten Produktmodelldaten mittels der orchestrierten Datenverarbeitungsprozesse basierend auf der konfigurierten Produktspezifikation zu den Neutraldaten der Produktspezifikation.

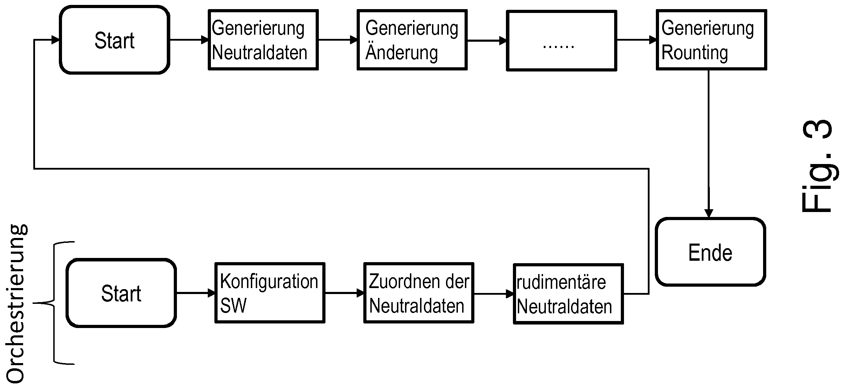

Die Fig. 3 zeigt eine schematische Darstellung einer Prozessvisualisierung eines Verfahrens zum Erzeugen von Neutraldaten für eine Produktspezifikation gemäß einem Ausführungsbeispiel der vorliegenden Erfindung.

Der in der Fig. 3 dargestellte Gesamtprozess umfasst einen Softwaremodulprozess, dargestellt in der rechten Spalte, und einen Orchestrierungsprozess, dargestellt in der linken Spalte.

Der Orchestrierungsprozess kann beispielsweise einen Auslösemechanismus aufweisen, wobei der Report aufgerufen wird, wenn ein neuer Verkaufsbeleg vorhanden ist.

Der Orchestrierungsprozess kann beispielsweise eine Startbedingung aufweisen, etwa, dass ein Verkaufsbeleg mit einem konfigurierten Produkt angelegt wird, und die Konfiguration steht als Position im Beleg zur Verfügung.

Der Orchestrierungsprozess kann beispielsweise als ein Überwachungsprozess ausgebildet sein und zum Erzeugen von Neutraldaten für eine Produktspezifikation ausgelegt werden.

Obwohl die vorliegende Erfindung anhand bevorzugter Ausführungsbeispiele vorstehend beschrieben wurde, ist sie nicht darauf beschränkt, sondern auf vielfältige Art und Weise modifizierbar. Insbesondere lässt sich die Erfindung in mannigfaltiger Weise verändern oder modifizieren, ohne vom Kern der Erfindung abzuweichen.

Ergänzend sei darauf hingewiesen, dass "umfassend" und "aufweisend" keine anderen Elemente oder Schritte ausschließt und "eine" oder "ein" keine Vielzahl ausschließt.

## Patentansprüche

1. Verfahren zum Erzeugen von Neutraldaten für eine Produktspezifikation, wobei das Verfahren in einem Rechnernetz durchgeführt wird und folgende Verfahrensschritte aufweist:
- Konfigurieren (S1) und Bereitstellen der Produktspezifikation;
- Semantisieren (S2) von Produktmodelldaten für eine Vielzahl von unterschiedlichen Produktspezifikationen aus einer Datenbank zu semantisierten Produktmodelldaten, wobei die Datenbank eine Vielzahl von Produktmodelldaten durch eine Variantenmodellierung bereitstellt;
- Orchestrieren (S3) von Datenverarbeitungsprozessen der Produktmodelldaten zu orchestrierten Datenverarbeitungsprozessen; und
- Transformieren (S4) der semantisierten Produktmodelldaten mittels der orchestrierten Datenverarbeitungsprozesse basierend auf der konfigurierten Produktspezifikation zu den Neutraldaten der Produktspezifikation.

2. Verfahren nach Patentanspruch 1, wobei das Verfahren durch eine verteilte Verarbeitung in dem Rechnernetz ausgeführt wird.

3. Verfahren nach Patentanspruch 1 oder 2, wobei als die Produktspezifikation eine:
i) kundenindividuelle Produktspezifikation; und/oder
ii) Bestandsprodukt-Spezifikation; und/oder
iii) Neuprodukt-Spezifikation
verwendet wird.

4. Verfahren nach einem der vorhergehenden Patentansprüche, wobei das Konfigurieren (S1) der Produktspezifikation von einem Webkonfigurator, einem Webshop, einem Simulationssystem, einem Enterprise-Resource-Planning-System, einem Produktionsleitsystem, oder einem Montagehilfsautomat durchgeführt wird.

5. Verfahren nach einem der vorhergehenden Patentansprüche, wobei die Produktmodelldaten für die Vielzahl der unterschiedlichen Produktspezifikationen basierend auf einem Entity-Relationship-Modell semantisiert werden.

6. Verfahren nach einem der vorhergehenden Patentansprüche, wobei die Variantenmodellierung durch einen webbasierten und/oder interaktiven Produktkonfigurator bereitgestellt wird.

7. Verfahren nach einem der vorhergehenden Patentansprüche, wobei die Neutraldaten in einem Neutraldaten-Format bereitgestellt werden, wobei das Neutraldaten-Format ein
i) XML-Format; und/oder
ii) plattformunabhängiges Datenformat; und/oder
iii) implementationsunabhängiges Datenformat; und/oder
iv) M2M-Datenformat
umfasst.

8. Verfahren nach einem der vorhergehenden Patentansprüche, wobei für das Orchestrieren (S3) der Datenverarbeitungsprozesse die Datenverarbeitungsdienste einer Produktionsanlage und/oder eines Backendsystems des Rechnernetzes orchestriert werden.

9. Vorrichtung zum Erzeugen für eine Produktspezifikation, wobei die Vorrichtung umfasst:
- ein Konfigurationsmodul (10), welches dazu ausgebildet ist, eine Produktspezifikation zu konfigurieren und bereitzustellen;
- ein Semantikmodul (20), welches dazu ausgebildet ist, Produktmodelldaten für eine Vielzahl von unterschiedlichen Produktspezifikationen zu semantisierten Produktmodelldaten aus einer mit dem Rechnernetz gekoppelten Datenbank zu semantisieren, wobei die Datenbank eine Vielzahl von Produktmodelldaten generiert durch eine Variantenmodellierung umfasst;
- ein Orchestrierungsmodul (30), welches dazu ausgebildet ist, Datenverarbeitungsprozesse der Produktmodelldaten zu orchestrierten Datenverarbeitungsprozessen zu orchestrieren; und
- ein Transformationsmodul (40), welches dazu ausgebildet ist, semantisierte Produktmodelldaten mittels der orchestrierten Datenverarbeitungsprozesse basierend auf der konfigurierten Produktspezifikation zu den Neutraldaten der Produktspezifikation zu transformieren.

10. Vorrichtung nach Patentanspruch 9, wobei die Vorrichtung als ein verteiltes Rechnernetz ausgebildet ist.

11. Vorrichtung nach Patentanspruch 9 oder 10, wobei das Konfigurationsmodul (10) dazu ausgebildet, als die Produktspezifikation eine:
i) kundenindividuelle Produktspezifikation; und/oder
ii) Bestandsprodukt-Spezifikation; und/oder
iii) Neuprodukt-Spezifikation
bereitzustellen.

12. Vorrichtung nach einem der vorhergehenden Patentansprüche 9 bis 11,
wobei das Konfigurationsmodul (10) dazu ausgebildet ist, das Konfigurieren und Bereitstellen der Produktspezifikation durch einen Webkonfigurator, einen Webshop, ein Simulationssystem, ein Enterprise-Resource-Planning-System, ein Produktionsleitsystem, oder einen Montagehilfsautomaten durchzuführen.

13. Vorrichtung nach einem der vorhergehenden Patentansprüche 9 bis 12,
wobei das Semantikmodul (20) dazu ausgebildet ist, die Produktmodelldaten für die Vielzahl der unterschiedlichen Produktspezifikationen basierend auf einem Entity-Relationship-Modell zu semantisieren.

14. Vorrichtung nach einem der vorhergehenden Patentansprüche 9 bis 13,
wobei die Vorrichtung dazu ausgebildet ist, die Neutraldaten in einem Neutraldaten-Format bereitzustellen, wobei das Neutraldaten-Format ein
i) XML-Format; und/oder
ii) plattformunabhängiges Datenformat; und/oder
iii) implementationsunabhängiges Datenformat; und/oder
iii) M2M-Datenformat
umfasst.

15. Rechnernetz umfassend die Vorrichtung nach einem der vorhergehenden Patentansprüche 9 bis 14, ferner umfassend eine Datenbank, welche einen webbasierten und/oder interaktiven Produktkonfigurator aufweist, welcher dazu ausgebildet ist, die Vielzahl der Produktmodelldaten durch die Variantenmodellierung zu generieren.
